# EUROPÄISCHE PATENTSCHRIFT

(11) **EP 1 235 285 B1**
(45) Veröffentlichungstag und Bekanntmachung des Hinweises auf die Patenterteilung: **19.12.2007**
(21) Anmeldenummer: 02003649.7
(22) Anmeldetag: 18.02.2002
(51) Int. Cl.: H01L 41/24, H01L 41/083

(54) **Verfahren zur Herstellung piezokeramischer Vielschichtaktoren**
Manufacturing method for piezoceramic multilayer actuators
Méthode de fabrication des actionneurs piézocéramiques multicouche

(30) Priorität: 21.02.2001 DE 10108314; 12.02.2002 DE 10205928
(43) Veröffentlichungstag der Anmeldung: 28.08.2002
(73) Patentinhaber: CeramTec AG Innovative Ceramic Engineering, 73207 Plochingen (DE)
(72) Erfinder: Schreiner, Hans-Jürgen, Dr., 91233 Neunkirchen am Sand-Rollhofen (DE); Bindig, Reiner, 95463 Bindlach (DE); Simmerl, Matthias, 91239 Henfenfeld (DE); Schmidt, Jürgen, 95615 Marktredwitz (DE)
(74) Vertreter: Uppena, Franz

(56) Entgegenhaltungen:
- EP-A- 0 247 540
- EP-A- 0 584 842
- EP-A- 0 977 284
- EP-A- 1 233 462
- WO-A-00/26972

## Beschreibung

Die Erfindung betrifft ein Verfahren zur Herstellung piezokeramischer Vielschichtaktoren entsprechend dem Oberbegriff des ersten Anspruchs.

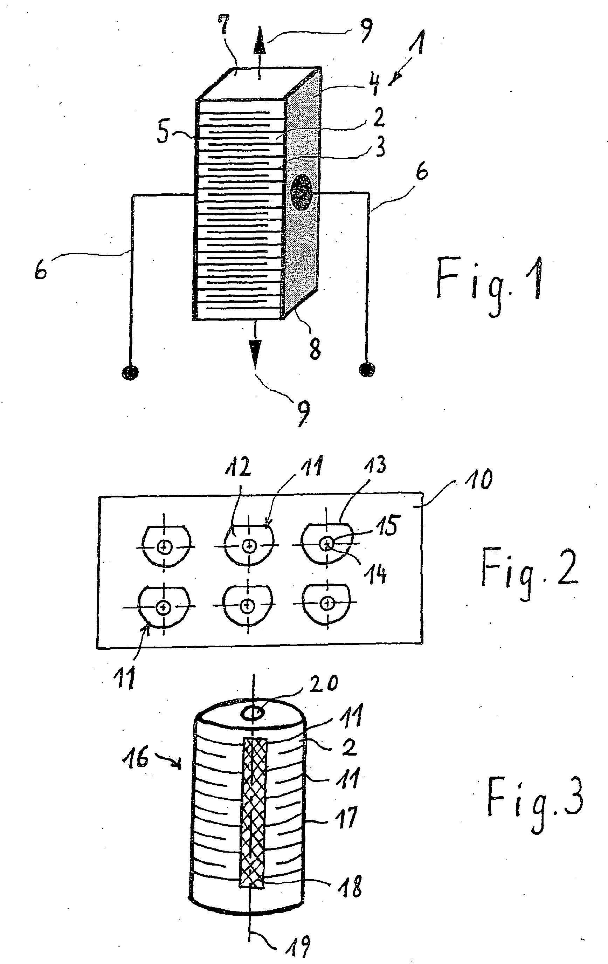

In Figur 1 ist ein piezokeramischer Vielschichtaktor 1 schematisch dargestellt. Der Aktor besteht aus gestapelten dünnen Schichten 2 piezoelektrisch aktiven Werkstoffs, beispielsweise Blei-Zirkonat-Titanat (PZT), mit dazwischen angeordneten leitfähigen Innenelektroden 3, die alternierend an die Aktoroberfläche geführt werden. Außenelektroden 4, 5 verbinden die Innenelektroden 3. Dadurch werden die Innenelektroden 3 elektrisch parallel geschaltet und zu zwei Gruppen zusammengefasst. Die beiden Außenelektroden 4, 5 sind die Anschlusspole des Aktors 1. Sie sind über die Anschlüsse 6 mit einer hier nicht dargestellten Spannungsquelle verbunden. Wird über die Anschlüsse 6 eine elektrische Spannung an die Außenelektroden 4, 5 gelegt, wird diese auf alle Innenelektroden 3 parallel übertragen und verursacht ein elektrisches Feld in allen Schichten 2 des aktiven Werkstoffs, der sich dadurch mechanisch verformt. Die Summe aller dieser mechanischen Verformungen steht an den Endflächen des Kopfbereichs 7 und des Fußbereichs 8 des Aktors 1 als nutzbare Dehnung und/oder Kraft 9 zur Verfügung.

Piezokeramische Vielschichtaktoren werden nach dem Stand der Technik als Monolithen ausgeführt, das heißt, der aktiven Werkstoff, auf dem vor dem Sintern durch ein Siebdruckverfahren Innenelektroden aufgetragen werden, wird als sogenannte Grünfolie zu einem Stapel aufeinandergelegt, der zu einem Grünkörper verpresst wird. Das Verpressen des Grünkörpers wird in der Regel durch Laminieren unter Druck- und Temperatureinwirkung in Laminierformen durchgeführt. Dieses Verfahren legt, begründet durch die verwendeten Laminierwerkzeuge, die äußere Form der Aktoren bereits weitgehend fest. Das Laminat wird in die einzelnen Aktoren aufgeteilt, die pyrolysiert und anschließend gesintert werden. Weil das Laminieren im ungesinterten Körper häufig Inhomogenitäten der Dichte erzeugt und die Schwindung beim keramischen Brand keine konstante Größe darstellt, kann die Endgeometrie der Aktoren nur durch Hartbearbeitung der gesinterten Aktoren in der geforderten Genauigkeit erzeugt werden. Dabei werden aber die in die Aktoren eingelagerten Innenelektrodenschichten ebenfalls mit bearbeitet. Werden die bearbeiteten Flächen nicht nachträglich elektrisch isoliert, so tritt beim aktiven Betrieb dieser piezokeramischen Vielschichtaktoren die Gefahr eines elektrischen Überschlages an der Aktoroberfläche auf, weil die Isolationsfeldstärke in Luft, die etwa 1000 V/mm beträgt, durch die Betriebsfeldstärken von bis über 2000 V/mm überschritten wird. Gleichzeitig führen durch die Hartbearbeitung verursachte Verschmierungen der Elektroden zusätzlich zu verringerter Isolationsfestigkeit und/oder Leckströmen.

Aus der EP 1 233 462 A2, die als Stand der Technik gemäß Artikel 54(3) EPÜ anzusehen ist, ist ein Vielschichtaktor bekannt, bei dem nach dem Sintern die Sinterhaut auf seiner Oberfläche belassen wird und nur die Bereiche zur Freilegung der Innenelektroden angeschliffen werden, an denen die Kontaktflächen der Innenelektroden mit der Außenelektrode verbunden werden.

Bei der Herstellung eines Vielschichtaktors, wie er aus der EP 0 247 540 A2 bekannt ist, werden Grünfolien mit Innenelektroden bedruckt, aus denen vor dem Laminieren die einzelnen Lagen des Aktors in den gewünschten Abmessungen ausgeschnitten und dann aufeinandergestapelt werden.

Aus der WO 00/26972 A1 ist ein Verfahren zur Herstellung mehrerer piezoelektrischer Aktoren bekannt, in dem mit Innenelektroden beschichtete Folien zu einem Stapel aufeinandergelegt, gepresst und gesintert werden und anschließend der Stapel in einzelne Aktoren zertrennt wird. Vor dem Stapeln und vor dem Sintern wird in die Folien zumindest eine Ausnehmung für jeden Aktor eingebracht und beim Stapeln werden diese Ausnehmungen exakt fluchtend übereinander angeordnet. Die Folien werden beim Stapeln mittels an dem Rahmenbereich der Folien vorgesehenen Zentrierbohrungen zentriert, in die Führungsstangen eingesetzt werden.

Es ist die Aufgabe der vorliegenden Erfindung ein Verfahren vorzustellen, das die Herstellung von Vielschichtaktoren vereinfacht und durch das die aufgezeigten Nachteile vermieden werden.

Die Lösung der Aufgabe erfolgt mit Hilfe der kennzeichnenden Merkmale des ersten Anspruchs. Vorteilhafte Ausgestaltungen der Erfindung werden in den Unteransprüchen beansprucht.

Durch Stapeln von Grünfolien aus piezokeramischem Werkstoff, die mit den entsprechenden Strukturen der Innenelektroden für mindestens einen piezokeramischen Vielschichtaktor bedruckt sind und durch entsprechendes Laminieren unter Druck von etwa 100 bar bei einer Temperatur von etwa 120 °C wird ein Grünkörper hoher mechanischer Festigkeit, gutem Zusammenhalt der Folienlagen, guter mechanischer Bearbeitbarkeit und homogener Dichte erhalten. Erfindungsgemäß ist es deshalb möglich, aus einem solchen Grünkörper als Laminat die Vielschichtaktoren leicht herauszutrennen und anschließend durch spanabhebende Bearbeitung in ihre Form zu bringen, die in der Regel bereits die endgültige Form ist, so dass die Aktoren nach dem Sintern keiner weiteren Nachbearbeitung bedürfen. Nur noch an den Anschlußflächen, wo die Innenelektroden an die jeweilige Außenelektrode angeschlossen werden sollen, muss die isolierende Sinterhaut entfernt werden, beispielsweise durch Schleifen. Wegen der hohen mechanischen Festigkeit der laminierten Blöcke sind alle spanabhebenden Bearbeitungen wie Drehen, Fräsen, Sägen, Bohren oder Schleifen möglich. Dabei werden die Körper weder beschädigt noch deformiert. Durch die geringere Härte des Werkstoffs gegenüber dem Sinterzustand ist der Verschleiß der Werkzeuge wesentlich geringer, wodurch eine kostengünstige Fertigung möglich ist.

Durch das Sintern bildet sich allseitig auf der Oberfläche des piezokeramischen Vielschichtaktors eine sogenannte Sinterhaut aus, die auch im Bereich der an die Oberfläche des Aktors tretenden Innenelektroden eine so hohe elektrische Isolationsfähigkeit aufweist, dass eine nachträgliche Isolation der Oberflächen des piezokeramischen Vielschichtaktors in der Regel unterbleiben kann.

Die gute Bearbeitbarkeit des Laminats ermöglicht es, dass durch geeignete Wahl und/oder Kombination von Bearbeitungsverfahren piezokeramische Vielschichtaktoren in unterschiedlichen Formen hergestellt werden können. Die Querschnittsflächen können kreisförmig, ellipsenförmig, viereckig oder vieleckig sein. Bereits vor dem Sintern können alle Kanten an den Grünkörpern gebrochen, gefast oder abgerundet werden. Die gute Bearbeitungsmöglichkeit des keramischen Werkstoffs in der Grünphase ermöglicht auch die Herstellung rotationssymmetrischer Formkörper.

Der laminierte Block mit dem mindestens einen Vielschichtaktor weist eine hohe Festigkeit und Formbeständigkeit auf. Dadurch ist es möglich, vor dem Sintern in den Block und oder den ungesinterten piezokeramischen Vielschichtaktor, eine oder mehrere Bohrungen oder Sacklöcher einzubringen, die zusätzlich mit einem Gewinde ausgestattet werden können. Eine solche Ausstattung kann vorteilhaft für spätere Anwendungen wie Befestigungen oder Anschlüsse genutzt werden. Weil durch die Bohrungen oder Sacklöcher sowie durch die Gewindeschnitte die Schichten der Innenelektroden durchbrochen werden, kann auch hierbei die beim Sintern entstehende Sinterhaut vorteilhaft als Isolierschicht genutzt werden.

Eine weitere Möglichkeit der Formgebung der Vielschichtaktoren besteht darin, dass bereits vor dem Laminieren in die Grünfolien Löcher in der erforderlichen Größe, Form und Anzahl in dem gleichen Arbeitsgang gestanzt werden, in dem die Grünfolien passend für die Laminierform ausgestanzt werden. Anschließend werden dann die mit den Innenelektroden bedruckten Grünfolien in der erforderlichen Anzahl und Anordnung so aufeinandergelegt, dass die Bohrungen oder Sacklöcher in der gewünschten Anordnung und Tiefe entstehen. Auch hier können nach dem Laminieren Gewinde in die Löcher geschnitten werden.

In die Bohrungen, durchgehenden Löcher oder Sacklöcher kann vor dem Laminieren zur Erhöhung der Stabilität und zur Wahrung der Formgenauigkeit mit einem Füllstoff ausgefüllt werden, der die beim Laminieren sonst eventuell auftretende plastische Deformation der Aussparungen verhindert. Dieser Füllstoff ist so ausgewählt, dass er unter den Laminierbedingungen nicht plastischer oder stärker deformierbar ist als der piezokeramische Werkstoff der Grünfolien.

Ein Füllstoff kann aus einem harten, formstabilen und während des Laminierens thermostabilen Werkstoff bestehen, beispielsweise aus Metall oder Keramik. Je nach Formgebung werden beispielsweise Stifte oder Gewindestifte in die Löcher oder Sacklöcher eingesetzt.

Weiterhin eignen sich plastische oder thermoplastische Füllstoffe, insbesondere ein hochflexibler Gummi oder ein gummiartiger Kunststoff. Auch hier kann der Füllstoff die Form eines Stiftes oder Gewindestiftes haben.

Die Stifte oder Gewindestifte werden nach dem Laminieren aus dem Laminat herausgezogen beziehungsweise herausgeschraubt.

Weiterhin eignen sich Füllstoffe, die etwa bis zur Erreichung der Laminiertemperatur formstabil bleiben. Beim Laminieren oder beim Sintern schmelzen diese Füllstoffe aus oder pyrolisieren. Beispielsweise Wachs oder niedrigschmelzende Polymere können durch Erwärmung aus dem Laminat entfernt werden. Als Füllstoff kann auch ein geeigneter organischer Werkstoff verwendet werden, wie er nach dem Stand der Technik zur Bildung poröser Keramiken bekannt ist, beispielsweise Ruß oder ein Polymer, der beim Laminieren oder Sintern bei Temperaturen bis zu 700 °C rückstandsfrei pyrolisiert.

Das thermische Entfernen kann auch durch Ausschmelzen und/oder thermische Zersetzung in einem dem Sintern vorgeschalteten thermischen Prozeß, beispielsweise einem angepassten Entbinderungsprozeß, erfolgen.

Anhand eines Ausführungsbeispiels wird die Erfindung näher erläutert. Es zeigen:
- Figur 2: eine Grünfolie mit mehreren Innenelektroden und
- Figur 3: einen nach dem erfindungsgemäßen Verfahren hergestellten Vielschichtaktor.

In Figur 2 ist eine bereits für die Laminierform ausgestanzte Grünfolie 10 aus piezokeramischem Werkstoff dargestellt. Auf dieser Grünfolie sind jeweils sechs Innenelektroden 11 aufgetragen, wobei dieses Auftragen üblicherweise im Siebdruck erfolgt. Die Belegung einer Grünfolie mit mehreren Innenelektroden ermöglicht die rationelle Herstellung mehrerer Vielschichtaktoren gleichzeitig. Von der kreisförmigen Querschnittsfläche 12 ist auf einer Seite ein Kreisabschnitt abgeschnitten, so dass die Fläche dort von einer Sekante 13 begrenz wird. Zentrisch zum Mittelpunkt 14 ist ein Loch 15 ausgestanzt.

Die Grünfolien werden in der erforderlichen Anzahl so zu einem Block übereinandergestapelt, dass die Innenelektroden übereinanderliegen. Die Anzahl der Folien richtet sich nach der Größe des Vielschichtaktors. Im vorliegenden Ausführungsbeispiel umfasst der Block sechs Vielschichtaktoren. Wegen der leichten Trennbarkeit werden die Vielschichtaktoren nach dem Laminieren, noch im Grünzustand, um die Innenelektroden herum voneinander getrennt. Anschließend kann, ebenfalls noch im Grünzustand, die Fertigbearbeitung der Vielschichtaktoren bis auf den vorgegebenen Gründurchmesser des Vielschichtaktors erfolgen. Danach werden erst die Vielschichtaktoren gesintert.

Die Anordnung der Innenelektroden 11 auf der Grünfolie 10 ist jeweils in derselben Ausrichtung. Es sind Innenelektroden derselben Polung. Die Innenelektroden der gegensätzlichen Polung können in derselben Weise hergestellt werden. Dabei ist aber deren Ausrichtung gegenüber der Ausrichtung der ihnen zugeordneten Innenelektrode gegensätzlicher Polung, also auf der nachfolgenden Grünfolie, um 180 Grad gedreht. Die Elektrodenlagen mit der gegensätzlichen Polarität wechseln sich also alternierend ab. In einem Block, der die Kontur eines Vielschichtaktors zeigt, bilden die übereinanderliegenden Löcher 15 eine durchgehende Ausnehmung.

Figur 3 zeigt in schematischer, stark vergrößerter Darstellung einen Vielschichtaktor 16, der nach dem erfindungsgemäßen Verfahren hergestellt wurde. Er hat einen kreisförmigen Querschnitt 12 und ist vollständig von einer Sinterhaut 17 überzogen. Die Innenelektroden 11 gleicher Polung der einen Polarität treten vollständig an der Umfangsfläche zutage, während bei den Innenelektroden der gegensätzlichen Polarität aufgrund des fehlenden Kreisabschnitts der Umfang unterbrochen ist. Diese Gestaltung wird vorteilhaft ausgenutzt, um auf den sich gegenüberliegenden Seiten des Vielschichtaktors, wo nur die Innenelektroden gleicher Polarität am Umfang zu sehen sind, die Innenelektroden gleicher Polarität an die jeweilige Außenelektrode 18 anzuschließen. Dazu wird in diesem Bereich durch Schleifen die Sinterhaut 17 entfernt und die Innenelektroden 11 werden an ihrer Umfangsfläche freigelegt. Zentrisch zur Achse 19 des Vielschichtaktors 16 verläuft eine durchgehende Ausnehmung 20, gebildet aus den übereinanderliegenden Löchern 15 in den Grünfolien 10, die für Befestigungszwecke genutzt werden kann.

## Patentansprüche

1. Verfahren zur Herstellung piezoelektrischer Vielschichtaktoren (16) bei dem dünne Schichten aus einem piezokeramischen Werkstoff, Grünfolien (10) genannt, auf die mindestens eine Innenelektrode (11) aufgebracht ist, so zu einem Block aufeinandergestapelt werden, dass die Innenelektroden (11) alternierend an sich gegenüberliegenden Flächen des Aktors (16) geführt werden, wo sie durch eine Außenelektrode (18) miteinander verbunden werden, dass der Block laminiert wird und aus diesem Block der mindestens eine Aktor (16) herausgetrennt wird und durch eine Bearbeitung seine Form erhält, dass vor dem Sintern in den Block beziehungsweise Aktor (16) eine oder mehrere Bohrungen oder Sacklöcher (15,20) eingebracht werden oder Grünfolien (10) mit einem oder mehreren Löchern (15) in Übereinanderlage der Löcher (15) zur Bildung der Bohrungen oder Sacklöcher (15,20) zu einem Aktor (16) gestapelt werden und der Aktor (16) anschließend gesintert wird, wobei die beim Sintern entstandene Sinterhaut als Isolierschicht genutzt wird und die Sinterhaut nur an den Stellen abgetragen wird, an denen die Innenelektroden (11) an die Außenelektroden (18) angeschlossen werden, **dadurch gekennzeichnet, dass** die Bohrungen beziehungsweise die Sacklöcher (15,20) in den Vielschichtaktoren (16) vor dem Laminieren zur Erhöhung der Stabilität und Wahrung der Formgenauigkeit und zur Verhinderung der plastischen Deformation der Aussparungen beim Laminieren mit einem Füllstoff gefüllt werden, der unter den Laminierbedingungen nicht plastischer oder stärker deformierbar ist als der piezokeramische Werkstoff der Grünfolien (10).

2. Verfahren nach Anspruch 1, **dadurch gekennzeichnet, dass** als Füllstoff ein harter, formstabiler und während des Laminierens thermostabiler Werkstoff verwendet wird.

3. Verfahren nach Anspruch 1 oder 2, **dadurch gekennzeichnet, dass** ein Füllstoff aus Metall oder Keramik oder einem anderen harten, formstabilen und während des Laminierens thermostabilen Werkstoff verwendet wird.

4. Verfahren nach Anspruch 1, **dadurch gekennzeichnet, dass** als Füllstoff ein plastischer oder thermoplastischer Werkstoff verwendet wird.

5. Verfahren nach Anspruch 4, **dadurch gekennzeichnet, dass** ein hochflexibler Gummi oder ein gummiartiger Kunststoff verwendet wird.

6. Verfahren nach einem der Ansprüche 1 bis 5, **dadurch gekennzeichnet, dass** der Füllstoff in Form von Stiften oder Gewindestiften eingesetzt wird.

7. Verfahren nach Anspruch 6, **dadurch gekennzeichnet, dass** die Stifte oder Gewindestifte nach dem Laminieren aus dem Laminat herausgezogen beziehungsweise herausgeschraubt werden.

8. Verfahren nach Anspruch 1, **dadurch gekennzeichnet, dass** ein Füllstoff verwendet wird, der etwa bis zur Erreichung der Laminiertemperatur formstabil bleibt und thermisch entfernt wird.

9. Verfahren nach Anspruch 8, **dadurch gekennzeichnet, dass** als Füllstoff ein Wachs oder ein niedrigschmelzendes Polymer verwendet wird und dass diese Füllstoffe beim Laminieren oder beim Sintern ausschmelzen.

10. Verfahren nach Anspruch 8, **dadurch gekennzeichnet, dass** als Füllstoff ein geeigneter organischer Werkstoff verwendet wird, der beim Laminieren oder Sintern rückstandsfrei pyrolisiert.

11. Verfahren nach Anspruch 8, **dadurch gekennzeichnet, dass** das thermische Entfernen durch Ausschmelzen und/oder thermische Zersetzung in einem dem Sintern vorgeschalteten thermischen Prozeß, beispielsweise einem angepassten Entbinderungsprozeß, durchgeführt wird.

## Claims

1. A process for the manufacture of piezoelectric multilayer actuators (16), in which thin layers made from a piezoceramic material, known as green films (10), onto which at least one internal electrode (11) is placed, are stacked one above the other into a block so that the internal electrodes (11) are led out alternately at opposing faces of the actuator (16), where they are interconnected by an external electrode (18), that the block is laminated and the at least one actuator (16) is separated from this block and obtains its shape by means of a machining operation, that prior to sintering one or more bore holes or blind holes (15, 20) is/are introduced into the block or actuator (16), or green films (10) having one or more holes (15) are stacked to form an actuator (16) with the holes (15) lying one of top of the other in order to form the bore holes or blind holes (15, 20), and the actuator (16) is then sintered, with the sinter skin produced by the sintering being used as an insulating layer and the sinter skin being abraded just at those points at which the internal electrodes (11) are connected to the external electrodes (18), **characterised in that** in order to increase stability and to maintain dimensional accuracy and to prevent plastic deformation of the recesses during lamination, the bore holes or the blind holes (15, 20) in the multilayer actuators (16) are filled prior to lamination with a filler which under lamination conditions is not more plastic or cannot be deformed to a greater degree than the piezoceramic material of the green films (10).

2. A process according to Claim 1, **characterised in that** a hard, dimensionally stable and, during lamination, thermally stable material is used as a filler.

3. A process according to Claim 1 or 2, **characterised in that** a filler made from metal or ceramic or another hard, dimensionally stable and, during lamination, thermally stable material is used.

4. A process according to Claim 1, **characterised in that** a plastic or thermoplastic material is used as a filler.

5. A process according to Claim 4, **characterised in that** a highly flexible rubber or a rubber-like plastic is used.

6. A process according to one of Claims 1 to 5, **characterised in that** the filler is used in the form of pins or threaded pins.

7. A process according to Claim 6, **characterised in that** following lamination, the pins or threaded pins are withdrawn or unscrewed from the laminate.

8. A process according to Claim 1, **characterised in that** a filler is used that remains dimensionally stable approximately until the lamination temperature is reached and is thermally removed.

9. A process according to Claim 8, **characterised in that** a wax or a low-melting-point polymer is used as a filler, and that these fillers melt out during lamination or sintering.

10. A process according to Claim 8, **characterised in that** a suitable organic material that pyrolizes without residues during lamination or sintering is used as a filler.

11. A process according to Claim 8, **characterised in that** the thermal removal is achieved by melting out and/or thermal decomposition in a thermal process preceding sintering, for example an appropriately designed binder-removal process.

## Revendications

1. Méthode de fabrication d'actionneurs piézocéramiques multicouches (16), selon laquelle
- des couches minces faites d'un matériau piézocéramique et appelées pellicules de base (10), sont déposées sur au moins une électrode interne (11) de manière qu'elles soient empilées pour donner un bloc,
- les électrodes internes (11) sont amenées alternativement sur les faces opposées de l'actionneur (16) où elles sont reliées entre elles par une électrode externe (18),
- le bloc est laminé et de ce bloc l'actionneur, au nombre d'un au moins, est séparé et reçoit sa forme par usinage,
- avant le frittage, dans le bloc ou l'actionneur (16) sont percés plusieurs alésages ou trous borgnes (15, 20), ou bien des pellicules de base (10) percées d'un ou plusieurs trous sont empilées avec superposition des trous (15) pour former des alésages ou des trous borgnes (15, 10), de manière à réaliser un actionneur (16),
- l'actionneur est ensuite fritté et la peau de frittage ainsi obtenue est utilisée comme couche isolante, puis cette couche est retirée aux endroits où les électrodes internes (11) sont raccordées aux électrodes externes (18),
cette méthode présentant les caractéristiques suivantes :
les alésages ou les trous borgnes (15, 20) réalisés dans les actionneurs multicouches (16), afin d'augmenter la solidité et d'assurer la conservation de la forme exacte et pour empêcher la déformation plastique des évidements lors du laminage, sont remplis avant le laminage d'un matériau de remplissage qui, dans les conditions de laminage, ne peut se déformer plastiquement plus que le matériau piézocéramique des pellicules de base (10).

2. Méthode de fabrication selon la revendication 1, **caractérisée en ce que** comme matériau de remplissage est utilisé un matériau dur, stable de forme et qui résiste à la chaleur pendant le laminage.

3. Méthode de fabrication selon la revendication 1 ou 2, **caractérisée en ce que** comme matériau de remplissage est utilisé un métal, une céramique ou un autre matériau dur, stable de forme et qui résiste à la chaleur pendant le laminage.

4. Méthode de fabrication selon la revendication 1, **caractérisée en ce que** comme matériau de remplissage est utilisé un matériau plastique ou thermoplastique.

5. Méthode de fabrication selon la revendication 4, **caractérisée en ce qu'**est utilisé un caoutchouc hautement flexible ou un matériau du genre caoutchouc.

6. Méthode de fabrication selon une des revendications 1 à 5, **caractérisée en ce que** le matériau de remplissage est utilisé sous la forme de broches ou de broches filetées.

7. Méthode de fabrication selon la revendication 6, **caractérisée en ce que** les broches ou les broches filetées sont retirées ou dévissées du produit laminé après le laminage.

8. Méthode de fabrication selon la revendication 1, **caractérisée en ce qu'**est utilisé un matériau de remplissage qui, à peu près jusqu'à ce que soit atteinte la température de laminage, reste stable de forme puis est éliminé par l'action de la chaleur.

9. Méthode de fabrication selon la revendication 8, **caractérisée en ce qu'**est utilisé comme matériau de remplissage une cire ou un polymère à bas point de fusion, qui fond lors du laminage ou du frittage.

10. Méthode de fabrication selon la revendication 8, **caractérisée en ce qu'**est utilisé comme matériau de remplissage un matériau organique approprié qui, lors du laminage ou du frittage, est pyrolisé sans laisser de résidus.

11. Méthode de fabrication selon la revendication 8, **caractérisée en ce que** l'élimination thermique par fusion et/ou décomposition thermique est réalisée au cours d'un processus thermique précédant le frittage, par exemple un processus adapté de rupture de liaisons.
